# EUROPÄISCHE PATENTSCHRIFT

(11) **EP 0 542 160 B1**
(45) Veröffentlichungstag und Bekanntmachung des Hinweises auf die Patenterteilung: **27.12.1995**
(21) Anmeldenummer: 92119076.5
(22) Anmeldetag: 06.11.1992
(51) Int. Cl.: C09J 175/04, C09D 175/04, C09J 163/00, C09D 163/00, H01B 3/30

(54) **Heisssiegelbeschichtung auf Dispersionsbasis**
Dispersion-based heat-seal coating
Revêtement thermoscellable à base de dispersion

(30) Priorität: 15.11.1991 DE 4137512
(43) Veröffentlichungstag der Anmeldung: 19.05.1993
(73) Patentinhaber: Henkel Kommanditgesellschaft auf Aktien, 40191 Düsseldorf (DE)
(72) Erfinder: Bolte, Gerd, Dr., W-4019 Monheim (DE); Henke, Günter, Dr., W-4040 Neuss (DE); Brüninghaus, Ulrike, W-4006 Erkrath (DE)

(56) Entgegenhaltungen:
- EP-A- 0 201 715
- WO-A-90/06330
- WO-A-91/18071
- DE-A- 3 247 756
- US-A- 3 971 745
- US-A- 4 278 578
- US-A- 4 772 643

## Beschreibung

Die Erfindung betrifft zweikomponentige, filmbildungsfähige Reaktivsysteme zum flächigen Verbinden und/oder Beschichten von Substraten, insbesondere für Heißsiegelbeschichtungen, auf Basis wäßriger Dispersionen
- mindestens eines mit Epoxiden härtbaren Harzes (I) und
- von Epoxidverbindungen als Härter (II)
und deren Verwendung. Desweiteren betrifft die Erfindung ein Verfahren zur Herstellung von Verbunden sowie klebstoffbeschichteten Substraten.

Zur Herstellung von Laminaten und Verbunden, insbesondere jedoch für die Herstellung von Basismaterialien für flexible gedruckte Schaltungen, werden spezielle Klebstoffsysteme benötigt. Die Anforderungen an derartige Systeme sind sehr hoch, da zum einen schwierig zu verklebende Materialien wie z.B. Kupferfolien mit Polyimidfolien zu verbinden sind, andererseits die Verbunde flexibel sowie weitestgehend hitzeresistent sein sollen. Dem Fachmann sind für derartige Zwecke lösungsmittelhaltige Klebstoffsysteme auf Basis modifizierter Polyurethan-, Polyester-, Acrylat- und Epoxidharze bekannt. Neben der grundsätzlichen Lösungsmittelproblematik haben derartige Systeme oftmals den Nachteil, daß die Aushärtezeiten viel zu lang sind, z.B. bis zu 14 Tagen bei Polyurethanklebstoffsystemen, oder die Aushärtetemperaturen zu hoch sind, z.B. bis zu 240°C bei Epoxidharz- oder Acrylat-Systemen. Zur Beseitung der Lösungsmittelproblematik wurden wasserbasierte Systeme entwickelt. So sind aus der JP 87/153371 sowie aus der JP 85/118781 Klebstoffe für flexible gedruckte Schaltungen auf wäßriger Basis bekannt, die Dispersionen von Acrylat-(Co)polymeren und von Epoxidverbindungen enthalten. Ein wesentlicher Nachteil derartiger Systeme sind die relativ langen Aushärtezeiten, z.B. 16 Stunden bei 130°C bei der JP 87/153371. Aus der JP 87/112676 sind wäßrige Polyurethanklebstoffe bekannt auf Basis Polyurethandispersionen (A) erhalten aus Polytetramethylenglykol (MG 400 bis 2000), einem organischen Diisocyanat und einer Dimethylolcarbonsäure sowie Hydrazin oder Dihydraziden als Kettenverlängerungsmittel neutralisiert mit tertiären Aminen und einer wasserlöslichen Verbindung (B) mit 2 oder mehr Epoxid- oder Aziridinringen pro Molekül. Wenn auch als Beispiel angeführt wird, daß verschiedene Folien mit diesem Klebstoff miteinander verbunden werden können, z.B. PET und Polypropylen, so findet der Fachmann keinen Hinweis darauf, daß sich derartige Klebstoffe für Heißsiegelbeschichtungen eignen könnten. Des weiteren finden sich keine Hinweise auf die Herstellung blockfesten Beschichtungen sowie auf die spezielle Verwendung zur Herstellung von flexiblen gedruckten Schaltungen.

In der älteren Anmeldung WO-A-9118071 werden zweikomponentige, filmbildungsfähige Reaktivsystem zum flächigen Verbinden und/oder Beschichten von Substraten, insbesondere für Heißsiegelbeschichtungen, auf Basis wäßriger Dispersionen
- mindestens eines mit Epoxiden härtbaren Harzes (I) und
- von Epoxidverbindungen als Härter (II) beschrieben. Sie sind dadurch gekennzeichnet, daß als härtbares Harz (Ia) Polyurethanpolymere mit gegenüber Epoxiden reaktiven funktionellen Gruppen und eine wäßrige Dispersion von Acrylat- und/oder Methacrylat-Homo- oder -Copolymeren mit Carboxyl- und/oder Methylolgruppen (Ib) enthalten sind.

In der EP 0 201 715 wird ein Polyester-Film beschrieben, der auf mindestens einer Seite eine Primer-Schicht enthält. Sie wird erhalten durch Vernetzung einer Polyepoxid-Komponente mit einer Polyurethan-Komponente, die zumindest eine funktionelle Gruppe enthält, unter anderem eine Carboxyl-Gruppe. Von einer weiteren Härterkomponente auf der Basis von Acrylat- und/oder Methacrylat-Polymeren ist keine Rede.
In der WO 90/6330 wird eine wäßrige Polyurethan-Dispersion beschrieben, die zur Beflockung von elastomeren Formkörpern sowie zur Heißversiegelung von Textilien verwendet werden kann. Auch hier werden reaktive Epoxid-Harze mit Polyurethanen vernetzt, die aufgrund des Kettenverlängerungsmittels noch reaktive Gruppen haben. Dabei handelt es sich unter anderem um Amino- und Alkohol-Gruppen. Von einem weiteren Harz neben dem Polyurethan-Härter ist ebenfalls keine Rede.

Aufgabengemäß sollen wasserbasierte Reaktivsysteme zur Verfügung gestellt werden, die in der Lage sind, auch bei schwierig zu verbindenden Substraten wie Polyimiden hohe Haftfestigkeiten zu erreichen. Darüber hinaus soll eine hohe Flexibilität, ein hoher Isolationswiderstand, eine hohe Temperaturstabilität sowie eine gute Lötbadbeständigkeit gewährleistet sein. Die Aushärtezeit soll relativ kurz und die Aushärtetemperatur unter 200°C liegen. Des weiteren soll die besondere Forderung der Blockfestigkeit erfüllt werden können. Darunter ist die Nicht-Klebrigkeit eines Films bei üblichen Raum- und Lagertemperaturen zu verstehen, der durch Beschichtung eines Substrats mit dem erfindungsgemäßen Reaktivsystem und anschließendem Trocknen hergestellt wurde. Es soll darüber hinaus eine neue Rohstoffbasis bzw. eine andere Polymerenklasse als Ausgangsmaterial für derartige Systeme erschlossen werden.

Die Aufgabe wurde erfindungsgemäß gelöst durch zweikomponentige, filmbildungsfähige Reaktivsysteme zum flächigen Verbinden und/oder Beschichten von Substraten, insbesondere für Heißsiegelbeschichtungen, auf Basis wäßriger Dispersionen mindestens eines mit Epoxiden härtbaren Harzes (I) und von Epoxidverbindungen als Härter (II), dadurch gekennzeichnet, daß als härtbares Harz (Ia) Polyurethanpolymere mit gegenüber Epoxiden reaktiven funktionellen Gruppen, außer Aminogruppen, und als weiteres härtbares Harz (Ib) wäßrige Dispersionen von Acrylat- und/oder Methacrylat-Homo- oder - Copolymeren mit Carboxyl- und/oder Methylolgruppen enthalten sind, sowie als drittes Harz entweder 2 bis 15 Gew.-%, bezogen auf den Festkörper-Gehalt, eines Polyaziridins oder 2 bis 30 Gew. -%, bezogen auf den Festkörper-Gehalt, eines Phenol-Resol-Harzes.

Das erfindungsgemäße zweikomponentige Reaktivsystem erhält also Dispersionen mindestens eines mit Epoxiden härtbaren Harzes (I) sowie dispergierte Epoxidverbindungen als Härter (II). Im Unterschied zu den weiter oben genannten beiden japanischen Anmeldungen besteht das in (I) enthaltene härtbare Harz (Ia) aus Polyurethanpolymeren mit gegenüber Epoxiden reaktiven funktionellen Gruppen. Als reaktive funktionelle Gruppen sind insbesondere Amino-, Carboxyl- und/oder Hydroxylgruppen geeignet. Bevorzugt sind Carboxylgruppen. Derartig modifizierte Polyurethanpolymere sind dem Fachmann bekannt.

Grundsätzlich gibt es eine Vielzahl von Grundstoffen, die für die Herstellung von Polyurethanen geeignet sind. Grob lassen diese sich in die sogenannte Polyolkomponente und die sogenannte Isocyanatkomponente unterteilen. Bei den Polyolen sind Polyesterpolyole, Polyetherpolyole und Polyesterpolyetherpolyole von besonderer Bedeutung. Im Sinne der Erfindung werden Polyurethane auf Basis von Polyesterpolyolen bevorzugt. Diese erhält man im allgemeinen durch Umsetzung mehrfunktioneller Alkohole mit mehrfunktionellen Carbonsäuren. Geeignete Isocyanate zur Herstellung von Polyurethanen sind beispielsweise aliphatische, aromatische und/oder alicyclische mehrfunktionelle Isocyanate. Exemplarisch seien 4,4'-Diphenylmethandiisocyanat (MDI), Isophorondiisocyanat (IPDI), Toluylendiisocyanat (TDI) und Tetramethylxyloldiisocyanat (TMXDI) genannt. Weitere Hinweise zu dem breiten Spektrum an geeigneten Polyol- und Isocyanatkomponenten kann der Fachmann der einschlägigen Fach- und Patentliteratur zu Polyurethanen entnehmen, so beispielsweise-der veröffentlichten europäischen Anmeldung 354 471. Auch der dort angeführte Schritt der Kettenverlängerung ist möglich. Allerdings sollten, ebenfalls aus den dort angeführten Gründen der physiologischen Unbedenklichkeit, keine Kettenverlängerungsmittel eingesetzt werden, die physiologisch bedenklich sind wie beispielsweise Hydrazin, Diaminodiphenylmethan oder die Isomeren des Phenyldiamins sowie die Carbohydrazide oder Hydrazide von Dicarbonsäuren.

Auch die Einführung der genannten, gegenüber Epoxiden reaktiven funktionellen Gruppen in das Polymergerüst ist dem Fachmann prinzipiell bekannt. So sind beispielsweise hydroxylgruppenhaltige Polyurethane dadurch zu erhalten, daß bei der Umsetzung von Polyol- und Isocyanatkomponente ein Verhältnis von OH- zu NCO-Gruppen gewählt wird, das größer 1 ist. Carboxylgruppen lassen sich z.B. einfügen, indem man der Polyolkomponente vor Umsetzung mit der Isocyanatkomponente einen Teil an Dihydroxycarbonsäuren zufügt. Geeignete aminogruppenhaltige Polyurethane lassen sich beispielsweise durch Umsetzung von isocyanatgruppenenthaltenden Polyurethanen mit mehrfunktionellen Aminoverbindungen herstellen, wenn die Isocyanatgruppen im Unterschuß vorliegen. Weitere Hinweise zur Einführung derartiger funktioneller Gruppen, insbesondere der im Sinne der Erfindung besonders bevorzugten Carboxylgruppen lassen sich ebenfalls der bereits genannten veröffentlichten europäischen Anmeldung entnehmen.

Die geeigneten Polyurethanpolymeren können auch unterschiedliche gegenüber Epoxiden reaktive Gruppen enthalten. Geeignet sind jedoch insbesondere solche, bei denen die Summe aus Säurezahl, OH-Zahl und Aminzahl im Mittel 0,1 bis 40 beträgt. Besonders geeignet sind Polyurethanpolymere, bei denen die genannte Summe im Bereich von 0,3 bis 20 liegt. Bevorzugt wird ein Bereich von 0,5 bis 5. Es werden grundsätzlich solche Polyurethane erfindungsgemäß bevorzugt, die jeweils mindestens im Mittel zwei gegenüber Epoxiden reaktive funktionelle Gruppen enthalten. Bei derartigen Polymeren sind jene in besonderer Weise geeignet, bei denen diese reaktiven Gruppen endständig angeordnet sind. Bezüglich der anwendungstechnischen Eigenschaften, insbesondere der Flexiblität und Haftfestigkeit, werden bevorzugt Polyurethane eingesetzt, die ein mittleres Molekulargewicht von etwa 7.000 bis 50.000 aufweisen. Besonders gute Ergebnisse werden mit Polyurethanen mit einem mittleren Molekulargewicht im Bereich von 10.000 bis 30.000 erreicht. Mit mittlerem Molekulargewicht ist in diesem Zusammenhang sowie im folgenden das Gewichtsmittel gemeint.

Geeignete Epoxidverbindungen sind dem Fachmann aus der Patentliteratur und auch aus Enzyklopädien bekannt. So ist z.B. im Ullmann, Enzyklopädie der technischen Chemie, 4. Auflage, Band 10, Verlag Chemie, Weinheim/Bergstraße 1974, S. 563 ff. ausführlich die Herstellung von Epoxiden, deren Eigenschaften und Verwendung beschrieben. Zu den technisch wichtigsten Epoxidverbindungen zählen solche auf Basis von Bisphenol-A und/oder Novolak. Neben diesen sind auch heterocyclische Epoxide besonders geeignet. Erfindungsgemäß werden Epoxidharzdispersionen eingesetzt. Prinzipiell sind alle dispergierbaren Epoxidharze geeignet. Dies gilt sowohl für emulgatorhaltige Dispersionen, als auch für entsprechende selbstemulgierende Systeme. Auch Epoxidverbindungen wie Triglycidylisocyanorat, Polyethylenglycoldiglycidylether oder Sorbitolpolyglycidylether sind geeignet. Anstelle der dispergierbaren Epoxidharze können ganz oder teilweise auch wasserlösliche Epoxidverbindungen eingesetzt werden. Die erfindungsgemäß geeigneten Epoxide enthalten bevorzugt im Mittel mindestens zwei Epoxygruppen. Besonders bevorzugt sind Epoxidverbindungen mit einem Epoxidäquivalent im Bereich von 100 bis 4.000. Dabei wird unter einem Epoxidäquivalent die Menge in Gramm verstanden, die ein Mol Epoxid enthält. Besonders gute Ergebnisse werden mit Epoxidverbindungen erthalten, bei denen dieser Wert zwischen 150 und 600 liegt.

Kennzeichnungsgemäß enthält die erfindungsgemäße Dispersion eines mit Epoxiden härtbaren Harzes (I) neben den bereits näher beschriebenen Polyurethanen (Ia) als weiteres härtbares Harz (Ib) Acrylat- und/oder Methacrylat-Homo- oder -Copolymere mit Carboxyl- und/oder Methylolgruppen in dispergierter Form. Derartig modifizierte (Meth-)Acrylatpolymere sind dem Fachmann bekannt. Für die Herstellung derartiger Polymere seien als geeignete (Meth-)Acrylate beispielhaft Acrylsäure und Methacrylsäure sowie deren Salze und Ester genannt. Vorzugsweise enthält die Alkoholkomponente dieser Ester 1 bis 6 C-Atome. Bei den erfindungsgemäß eingesetzten Polymerdispersionen bzw. -emulsionen kann der Fachmann zweckmäßigerweise auf solche zurückgreifen, die durch Emulsionspolymerisation hergestellt wurden. Selbstverständlich können die genannten Monomeren auch mit anderen ethylenisch ungesättigten Monomeren (co)polymerisiert werden soweit diese copolymerisierbar sind. Derartig geeignete Monomere sind alle diejenigen, die ethylenisch ungesättigte bzw. vinylische Gruppen enthalten.

Zu den Vinylverbindungen zählen z.B. das Vinylchlorid sowie die Vinylester wie Vinylacetat, Vinylpropionat aber auch Vinylfettsäureester wie Vinyllaurat und desweiteren Vinylalkohol. Geeignete Styrolverbindungen sind Styrol, Halogenstyrole wie Chlorstyrol, Fluorstyrol und Jodstyrol, Alkylstyrole wie Methylstyrol und 2,4-Diethylstyrol, Cyanostyrole, Hydroxystyrole, Nitrostyrole, Aminostyrole und/oder Phenylstyrole. Zu den geeigneten Derivaten der Acrylverbindungen zählt beispielsweise auch Acrylnitril. Die in den vorstehend beschriebenen Polymeren erfindungsgemäß enthaltenen Carboxylgruppen lassen sich beispielsweise durch die Mitverwendung von Acrylsäure und/oder Methacrylsäure als Monomere bei der Polymerisation einfügen. Methylolgruppen erhält man beispielsweise durch die Mitverwendung von Hydroxystyrolen oder durch Einpolymerisieren von Vinylacetat und anschließender Verseifung.

Wie bereits erwähnt, ist dem Fachmann seit langem bekannt, daß derartige Monomere sich unter den Bedingungen der Emulsionspolymerisation in einem wäßrigen Medium zu Polymeren addieren lassen wie beispielsweise im genannten Ullmann, Band 19, S. 11-21, S. 132 ff. und S. 370-373 sowie in Encyclopedia of Polymer Science and Engineering, Volume 6, Wiley & Sons, New York 1986, S. 1-51 beschrieben. Zu den geeigneten Monomeren zählen z.B. Vinylverbindungen, die bereits angeführten Acrylate sowie entsprechende Derivate.

Als geeignete Polymere im Sinne der Erfindung seien beispielsweise (Meth)acryl-Styrol-Acrylnitril-Copolymere oder Polybutylmethacrylat genannt. Geeignet sind auch die Homopolymeren der Acrylsäure sowie der Methacrylsäure. Besonders bevorzugt werden vorstehend beschriebene Polymere, wenn sie ein mittleres Molekulargewicht von 50.000 bis 300.000 aufweisen. Im Sinne der Erfindung bevorzugt sind solche Homo- oder Copolymeren, deren Summe von Säurezahl und OH-Zahl im Bereich von 1 bis 40 liegt. Besonders gute Ergebnisse weisen die genannten Polymeren auf, wenn diese Summe zwischen 3 und 15, insbesondere jedoch im Bereich von 4 bis 10 liegt.

Eine besondere Bedeutung kommt hinsichtlich der anwendungstechnischen Ergebnisse dem Verhältnis der härtbaren Harze zu. Grob gesagt gilt dabei die Regel, daß mit erhöhtem Polyurethananteil der aus dem Reaktivsystem entstehende Film flexibler wird, während durch Erhöhung des Anteils des anderen härtbaren Harzes die Temperaturstabilität begünstigt wird. Schon ein relativ kleiner Anteil an (Ib) führt zu deutlich verbesserten Werten hinsichtlich der letztgenannten Eigenschaft. Ein bevorzugter Bereich liegt deshalb zwischen 99 : 1 bis 25 : 75. Ein besonders optimaler und deshalb bevorzugter Bereich von (Ia) zu (Ib) liegt zwischen 98 : 2 bis 50 : 50. Die genannten Verhältnisse beziehen sich auf den Festkörpergehalt der Dispersion.

Ebenfalls von besonderer Bedeutung ist das Verhältnis von härtbarem Harz (I) zu Härter (II). Die Verhältnisse der einzelnen Komponenten zueinander sowie die Spezifikation dieser Komponenten beeinflussen selbstverständlich im gegenseitigen Wechselspiel die anwendungstechnischen Eigenschaften der erfindungsgemäßen Reaktivsysteme bzw. der daraus gebildeten Filme. So lassen sich über das Verhältnis der Mengen der einzelnen Komponenten sowie der Molekulargewichte und Funktionalitäten der Komponenten Reaktivsysteme innerhalb eines breiten Spektrums anwendungstechnischer Eigenschaften formulieren. So können sowohl Formulierungen mit einer hohen Anfangsklebrigkeit als auch solche, die eine besonders blockfeste Beschichtung ergeben komponiert werden. Das Gewichtsverhältnis von Harz (I) zu Härter (II) kann daher in einem bevorzugten Bereich von 1 : 5 bis 10 : 1 variieren. Insbesondere ist ein Bereich von 1 : 1 bis 5 : 1 bevorzugt, in dem optimale Resultate erzielt werden.

Um eine zweistufige Aushärtung, nämlich bei Raumtemperatur sowie bei erhöhter Temperatur, zu ermöglichen und um die Ausbildung eines sogenannten "Interpenetrating Net works" (IPN) zu erreichen, enthält die erfindungsgemäße Dispersion neben den beiden Komponenten (I) und (II) auch noch entweder 2 bis 15 Gew.-%, bezogen auf den Festkörper-Gehalt, eines Polyaziridins oder 2 bis 30 Gew.-%, bezogen auf den Festkörper-Gehalt, eines Phenol-Resol-Harzes.

Bei dem Polyaziridin handelt es sich um ein polyfunktionelles Aziridin mit der allgemeinen Formel 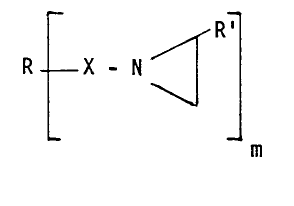
wobei
- R: ein organisch aliphatischer Rest oder ein H,
- X: eine Alkylen-Gruppe, die eine Ester-, Ether-, Amid- oder ähnliche inerte Gruppe enthalten kann,
- R': eine Alkylgruppe mit 1 bis 10 C-Atomben und
- m: eine Zahl von 2 bis 4 ist.
Es kann bekanntlich hergestellt werden durch Umsetzung von Alkylaziridinen mit gegen NH reaktiven Gruppen enthaltende Verbindungen. Bevorzugte Polyaziridine sind solche mit R' = Methyl, Ethyl, Propyl, Butyl, 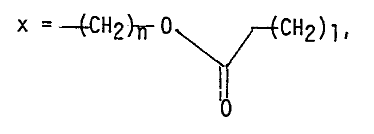
n = 1 bis 3, 1 = 1 bis 3, m = 2 bis 3 und R = CH₃-CH₂-C-Rest.

Der Zusatz des Polyaziridins bewirkt
- eine Verbesserung der Haftung bei Kaschiertemperatur zwischen Raumtemperatur und 90 °C,
- eine beschleunigte Aushärtung bei Raumtemperatur,
- eine Verbesserung der Temperatur- und Chemikalienbeständigkeit bei Raumtemperatur-Aushärtung.

Bei dem Phenol-Resol-Harz handelt es sich ebenfalls um bekannte Produkte. Sie werden erhalten durch Kondensation von Phenolen, Kresolen, u.ä. mit Formaldehyd. Bevorzugt sind flüssige Phenolresole. Ihr Zusatz bewirkt eine weitere Verbesserung der Temperaturbeständigkeit des Klebstoffilmes.

In einer besonderen Ausführungsform der Erfindung können in den Reaktivsystemen neben den Dispersionen von Harz (I) und Härter (II) auch übliche Zusatzstoffe bis zu einer Gesamtmenge von 30 Gew.-%, bezogen auf den Gesamtfestkörpergehalt des Reaktivsystems, enthalten sein. Einige übliche Zusatzstoffe werden im folgenden beispielhaft angeführt. Es können Katalysatoren wie beispielsweise tertiäre Amine oder Phosphorsäure bzw. deren Derivate enthalten sein, vorzugsweise bis zu 1 Gew.-%. Haftvermittler wie Silane, Titanate und Zirkonate können einen Anteil bis zu 1 Gew.-% aufweisen. Um die Oberfläche bei der Filmbildung lange offen zu halten, können hochsiedende Lösungsmittel bis zu 5 Gew.-% zugesetzt werden. Entschäumer und Benetzungshilfen sind üblicherweise bis zu 2 Gew.-% enthalten. Als Vernetzer bzw. Benetzungshilfe können beispielsweise Säureanhydride oder auch Styrol-Maleinsäureanhydrid-Harze bis zu 10 Gew.-% enthalten sein. Für besondere Anforderungen kann ein Flexibilisator, beispielsweise NBR-Kautschuk mit einem Molekulargewicht von 30.000 und 200.000 bis zu 10 Gew.-% zugesetzt werden. Als Weichmacher können Polyester mit einem mittleren Molekulargewicht von etwa 600 bis 15.000 oder auch Glykolether bis zu 5 Gew.-% enthalten sein. Weitere mögliche Zusatzstoffe wie Flammschutzmittel, Konservierungsmittel usw. sowie deren wirksame Mengen sind dem Fachmann aus der Literatur bekannt und werden hier nicht weiter aufgeführt. Auch die vorstehend gemachten Gewichtprozentangaben beziehen sich auf den Gesamtfestkörpergehalt des Reaktivsystems. Dieser liegt vorzugsweise im Bereich von 30 Gew.-% bis 75 Gew.-%, insbesondere im Bereich von 40 Gew.-% bis 65 Gew.-%.

Mittels der erfindungsgemäßen Reaktivsysteme lassen sich klebstoffbeschichtete Substrate herstellen, wie sie beispielsweise zur Herstellung flexibler gedruckter Schaltungen geeignet sind. Dabei wird so vorgegangen, daß das Reaktivsystem nach innigem Vermischen der Dispersionen von Harzen (I) und Härter (II) auf das Substrat, beispielsweise eine Metallfolie wie Kupferfolie, aufgetragen wird. Dies kann durch Walzen, Sprühen, Streichen, Rakeln oder Tauchen vorgenommen werden. Die Schichtdicke des aufgetragenen Reaktivsystems beträgt dabei im allgemeinen 15 bis 40 »m. Bevorzugt ist eine Schichtdicke von 20 bis 25 »m. Anschließend wird das so beschichtete Substrat bei einer Temperatur getrocknet, die unterhalb der Reaktivierungstemperatur liegt. Die Trocknungstemperatur sollte also 120°C nicht oder nicht wesentlich überschreiten. Die Trocknung kann beispielsweise in üblichen Trockenkanälen erfolgen. Bei einem gängigen Trockenkanal von 4 m Länge kann beispielsweise bei Temperaturen von 120°C und einem Durchsatz von etwa 4000 m³ Luft pro Stunde bei der erfindungsgemäßen Beschichtung von Folien mit Foliengeschwindigkeiten von 10 bis 20 Meter pro Minute gearbeitet werden. Man erhält so ein klebstoffbeschichtetes Substrat welches blockfest ist, d.h. bei normalen Lager- und Raumtemperaturen nicht klebrig ist.

Gegenüber dem bisherigen Stand der Technik bieten derartige blockfeste Systeme den Vorteil, daß zur Lagerung das Substrat auf der beschichteten Seite nicht durch eine zusätzliche Schutzfolie abgedeckt werden muß. Erfindungsgemäß beschichtete Folien können so in Form von schutzschicht- bzw. deckfolienfreien Rollen gelagert werden. Bei der Weiterverwendung dieser erfindungsgemäß hergestellten beschichteten Substrate entfällt somit auch der Arbeitsschritt des Entfernens der Schutz- bzw. Abdeckfolie. Derartig erfindungsgemäß beschichtete Substrate können in einem Verfahren zur Herstellung von Laminaten bzw. Verbunden weiterverarbeitet werden. Dazu werden diese mit einem weiteren Substrat heißverpreßt. Darunter versteht man, daß das klebstoffbeschichtete Substrat durch Hitze reaktiviert wird und durch Druck mit dem anderen Substrat flächig verbunden wird und anschliessend die Aushärtung erfolgt. Der Preßdruck beim Vorgang des Heißverpressens liegt maschinenabhängig und abhängig von den herzustellenden Laminaten bzw. Verbunden üblicherweise im Bereich von 5 bis 200 bar. Die Einstellung des für die jeweilige Kombination optimalen Drucks liegt im Erfahrungsbereich des Fachmanns. Reaktivierung und Aushärtung erfolgen vorzugsweise bei Temperaturen zwischen 140°C bis 170°C. Ein weiterer Vorteil der Erfindung liegt hier in den geringen Aushärtezeiten, die im Bereich von 30 bis 60 Minuten liegen können.

Selbstverständlich können die erfindungsgemäßen Reaktivsysteme auch zur in-line-Herstellung von Laminaten bzw. Verbunden verwendet werden. Hierbei entfällt die Zwischenlagerung. Vielmehr werden nach dem Beschichten, gegebenenfalls nach kurzem Vortrocknen des aufgetragenen Reaktivsystems, die Substrate unmittelbar anschließend (in-line) flächig miteinander verbunden und das Reaktivsystem gehärtet. Es entfällt hier also der Schritt der Zwischenlagerung des beschichteten Substrats (off-line-Verfahren). Sowohl für das in-line-als auch für das off-line-Verfahren gilt selbstverständlich, daß auch Laminate bzw. Verbunde mit mehr als zwei Substraten hergestellt werden können, wobei diese aus unterschiedlichsten Materialien bestehen können. Bei der in-line-Kaschierung kann der Fachmann das Verhältnis der Harze (Ia) und (Ib) untereinander sowie zu der Härterkomponente wie bereits beschrieben so wählen, daß das erfindungsgemäße Reaktivsystem eine etwas höhere Anfangsklebrigkeit aufweist. Dies geht zwar oftmals zu Lasten der Blockfestigkeit, welche jedoch bei dem in-line-Verfahren keine Rolle spielt.

Die erfindungsgemäßen Reaktivsysteme sind also in besonderer Weise geeignet zur Herstellung von mehrschichtigen Verbunden bzw. Laminaten. Die Substrate können dabei Metallfolien, Kunststoffolien, Gewebe, Vliese, Spezialpapiere und/oder Kartons sein. Beispielhaft seien als Metallfolien Kupfer-, Aluminium-, Blei- und Konstantanfolien aufgeführt. Als Kunststoffolien gut geeignet sind Folien auf Basis von Polyethylenterephthalat (PETP), Polyimid (PI), Polycarbonat (PC), Polyesteretherketon (PEEK) und sogenannte liquid cristal polymers (LCP). Desweiteren sind beispielsweise Gewebe aus PETP oder Polyamid (PA) gut geeignet. Als Vliese können solche aus PETP oder Polyaramid eingesetzt werden. Bei denen Spezialpapieren und Kartons sind solche auf Basis von Polyaramid oder Preßspan ebenfalls gut geeignet.

Erfindungsgemäß beschichtete Kupferfolien ergeben unter Einfluß von Wärme und Druck in der beschriebenen Weise mit anderen flexiblen Substraten wie Kapton^{R} oder Polyesterfolie Verbunde, die zur Herstellung flexibler, gedruckter Schaltungen geeignet sind. Die derartige Weiterverarbeitung heißsiegelbeschichteter Folien wird als Trockenkaschierung bezeichnet.

Die erfindungsgemäßen Reaktivsysteme ergeben nach thermischer Aushärtung Filme, die in den genannten Laminaten bzw. Verbunden hohe mechanische, thermische und chemische Stabilität aufweisen. Die erfindungsgemäßen Reaktivsysteme sind neben der Herstellung von hochtemperaturbeständigen flexiblen gedruckten Schaltungen auch für die Herstellung von hochtemperaturbeständigen Isoliermaterialien verwendbar. Unter Isoliermaterialien werden hier insbesondere Kabelumwicklungen, Abdeckfolien für Schaltungen und Wicklungen für Spulen verstanden.

Die Erfindung wird im folgenden anhand bevorzugter Ausführungsbeispiele näher erläutert.

### Beispiele

### Beispiel 1

Das Vergleichsreaktivsystem auf wäßriger Basis enthält in dispergierter Form
- 5 GT: eines carboxylgruppenhaltigen Polyesterurethans mit einem mittleren Molekulargewicht von etwa 25.000 und einer Säurezahl von 0,7 ± 0,3
- 5 GT: eines Methacryl-Styrol-Acrylnitril-Copolymeren mit einem mittleren Molekulargewicht von etwa 200.000 und einer Säurezahl von 5,5 ± 0,5 sowie
- 5 GT: eines Epoxids auf Basis Bisphenol-A mit einem Epoxidäquivalent von etwa 500
Die obengenannte Rezeptur ergibt nach der Trocknung bei ca. 120°C blockfeste Filme.

### Beispiel 2

Das Vergleichsreaktivsystem auf wäßriger Basis enthält in dispergierter Form
- 31 GT: eines carboxylgruppenhaltigen Polyurethans mit einem mittleren Molekulargewicht von etwa 25.000 und einer Säurezahl von 0,7 ± 0,3
- 8 GT: eines carboxylgruppenhaltigen Polyurethans mit einem mittleren Molekulargewicht von etwa 10.000 und einer Säurezahl von 0,7 ± 0,3
- 1 GT: eines Methacryl-Styrol-Acrylnitril-Copolymeren mit einem mittleren Molekulargewicht von etwa 200.000 und einer Säurezahl von 5,5 ± 0,5 sowie
- 5 GT: eines Epoxids auf Basis Bisphenol-A mit einem Epoxidäquivalent von etwa 500
- 5 GT: eines Epoxids auf Basis Bisphenol-A mit einem Epoxidäquivalent von 170
Dieses Reaktivsystem ergibt nach Trocknung eine Beschichtung mit hoher Anfangsklebrigkeit und eignet sich sich insbesondere für in-line-Kaschierungen.

Die Mengenangaben in Beispiel 1 und 2 beziehen sich auf den jeweiligen Festkörpergehalt. GT = Gewichtsteile

### Beispiel 3

Auf eine Kupferfolie von 35 »m wurde ein Reaktivsystem nach Beispiel 1 mit einer Dicke von 20 - 25 »m aufgegeben. Nach der Trocknung bei 120°C ergab sich ein 20 »m dicker geschlossener blockfreier Klebstoffilm.

### Beispiel 4

Die beschichtete Kupferfolie nach Beispiel 3 wurde gegen eine 23 »m starke Polyethylenterephthelatfolie bei 140°C kaschiert. Beim Test auf Verbundhaftung kam es zum Materialriß. Beim Test auf Temperatur-Stabilität zeigte sich nach 1 Tag bei 155°C weder Delamination noch Blasenbildung. Nach einer halbstündigen Temperung bei 170°C wurde eine Lötbadbeständigkeit über 45 Sekunden bei 230°C festgestellt.

### Beispiel 5

Die beschichtete Kupferfolie nach Beispiel 3 wurde gegen eine 50 »m starke Kapton^{R}-Folie bei 170°C kaschiert. Beim Test auf Verbundhaftung kam es zu Materialriß. Beim Test auf Temperaturstabilität zeigte sich nach einem Tag bei 220°C keine Delamination oder Blasenbildung. Nach einer halbstündigen Temperung bei 170°C wurde eine Lötbadbeständigkeit über 60 Sekunden bei 288°C festgestellt.

### Beispiel 6

Eine Polyesterfolie wurde mit einem Reaktivsystem gemäß Beispiel 1 beschichtet, getrocknet und anschließend mit einer Polyaramidfolie bei 140°C kaschiert. Der Test auf Verbundhaftung ergab Materialriß. Beim Test auf Temperaturbeständigkeit zeigte sich nach 1 Tag bei 155°C weder Delamination noch Blasenbildung.

### Beispiel 7

Eine Polyesterfolie wurde mit einem Reaktivsystem nach Beispiel 1 beschichtet und nach dem Trocknen mit einem Preßspansubstrat heißverpreßt. Auch hier wurde beim Test auf Verbundhaftung Materialriß erhalten. Beim Test auf Temperaturstabilität ergab sich nach einem Tag bei 130°C weder eine Ablösung der Substrate noch eine Blasenbildung.

### Beispiel 8

Die positive Wirkung von Polyaziridin zeigt folgendes Beispiel: Eine Polyesterfolie wurde mit einem Reaktivsystem gemäß Beispiel 2, dem 5 % des Polyazaridins CROSSLINKER CX-100 (Fa. ICI), bezogen auf den Festkörper-Gehalt, zugesetzt wurden, beschichtet, getrocknet und bei ca. 60 °C in-line gegen Polyaramidpapier kaschiert. Der Test auf Verbundhaftung ergab Materialabriß. Der Test auf Temperaturbeständigkeit zeigte nach 48 h bei 155 °C weder Delamination noch Blasenbildung.

### Beispiel 9

Die positive Wirkung eines Phenol-Resol-Harzes zeigt folgendes Beispiel:
a) 2 Gewichtsteile des im Beispiel 1 beschriebenen Polyurethans,
   10 Gewichtsteile des im Beispiel 1 beschriebenen Acrylestercopolymers,
   6 Gewichtsteile des im Beispiel 1 beschriebenen Epoxidharzes wurden gemischt, auf eine Cu-Folie aufgetragen und bei 120 °C getrocknet.
b) Der obengenannten Mischung wurde 1 Gewichtsteil eines flüssigen Phenolresolharzes zugegeben und die Mischung ebenfalls auf eine Cu-Folie aufgebracht und bei 120 °C getrocknet.

Beide Beschichtungen wurden mit 8 Lagen eines Phenolharzprepregs bei 170 °C für 1 h verpreßt.
Die Verbundhaftung der Probe a) lag bei 4,2 bis 4,5 N/3 mm, die der Probe b) bei 4,6 bis 4,9 N/3 mm. Die Lötbadbeständigkeit der Probe a) betrug 2 s, die der Probe b) 22 s bei 260 °C.

## Patentansprüche

1. Zweikomponentige, filmbildungsfähige Reaktivsysteme zum flächigen Verbinden und/oder Beschichten von Substraten, insbesondere für Heißsiegelbeschichtungen, auf Basis wäßriger Dispersionen
- mindestens eines mit Epoxiden härtbaren Harzes (I) und
- von Epoxidverbindungen als Härter (II),
dadurch gekennzeichnet, daß als härtbares Harz (Ia) Polyurethanpolymere mit gegenüber Epoxiden reaktiven funktionellen Gruppen, außer Aminogruppen, und als weiteres härtbares Harz (Ib) wäßrige Dispersionen von Acrylat- und/oder Methacrylat-Homo- oder Copolymeren mit Carboxyl- und/oder Methylolgruppen enthalten sind, sowie als drittes Harz entweder 2 bis 15 Gew.-%, bezogen auf den Festkörper-Gehalt, eines Polyaziridins oder 2 bis 30 Gew.-%, bezogen auf den Festkörper-Gehalt, eines Phenol-Resol-Harzes.

2. Zweikomponentige Reaktivsysteme nach Anspruch 1, dadurch gekennzeichnet, daß das Gewichtsverhältnis der härtbaren Harze (Ia) zu (Ib) im Bereich von 99 : 1 bis 25 : 75, insbesondere im Bereich von 98 : 2 bis 50 : 50, liegt.

3. Zweikomponentige Reaktivsysteme nach einem der vorstehenden Ansprüche, dadurch gekennzeichnet, daß das Gewichtsverhältnis von härtbarem Harz (I) zu Härter (II) im Bereich von 1 : 5 bis 10 : 1, bevorzugt im Bereich 1 : 1 bis 5 : 1, liegt.

4. Zweikomponentige Reaktivsysteme nach einem der vorstehenden Ansprüche, dadurch gekennzeichnet, daß die den gegenüber Epoxiden reaktiven funktionellen Gruppen der Polyurethanpolymere Carboxyl- und/oder Hydroxylgruppen, insbesondere Carboxylgruppen, sind.

5. Zweikomponentige Reaktivsysteme nach einem der vorstehenden Ansprüche, dadurch gekennzeichnet, daß die Polyurethanpolymeren ein mittleres Molekulargewicht von 7.000 bis 50.000, insbesondere von 10.000 bis 30.000, aufweisen.

6. Zweikomponentige Reaktivsysteme nach einem der vorstehenden Ansprüche, dadurch gekennzeichnet, daß die Polyurethanpolymere jeweils mindestens im Mittel zwei gegenüber Epoxiden reaktive funktionelle Gruppen enthalten.

7. Zweikomponentige Reaktivsysteme nach einem der vorstehenden Ansprüche, dadurch gekennzeichnet, daß die Summe von Säurezahl, OH-Zahl und Aminzahl der Polyurethanpolymeren im Mittel 0,1 bis 40, insbesondere 0,3 bis 20, vorzugsweise 0,5 bis 5, beträgt.

8. Zweikomponentige Reaktivsysteme nach einem der vorstehenden Ansprüche, dadurch gekennzeichnet, daß die Acrylat- und/oder Methacrylat-Homo- und/oder -Copolymeren ein mittleres Molekulargewicht von 50.000 bis 300.000 aufweisen.

9. Zweikomponentige Reaktivsysteme nach einem der vorstehenden Ansprüche, dadurch gekennzeichnet, daß die Acrylat- und/oder Methacrylat-Homo- und/oder -Copolymeren eine Summe von Säurezahl und OH-Zahl im Bereich von 1 bis 40, insbesondere 3 bis 15, vorzugsweise 4 bis 10, aufweist.

10. Zweikomponentige Reaktivsysteme nach einem der vorstehenden Ansprüche, dadurch gekennzeichnet, daß die Epoxidverbindungen ein Epoxidäquivalent im Bereich von 100 bis 4.000, insbesondere 150 bis 600, aufweisen.

11. Zweikomponentige Reaktivsysteme nach einem der vorstehenden Ansprüche, dadurch gekennzeichnet, daß zumindest überwiegend Epoxidverbindungen auf Basis Bisphenol-A, Novolak und/oder heterocyclische Epoxide enthalten sind.

12. Zweikomponentige Reaktivsysteme nach einem der vorstehenden Ansprüche, dadurch gekennzeichnet, daß sie neben den Dispersionen von Harz (I) und Härter (II) aus üblichen Zusatzstoffen wie Katalysatoren, Haftvermittler, Lösungsmittel, Benetzungsvermittler, Entschäumer, Weichmacher bis zu einer Gesamtmenge von 30 Gew.-%, bezogen auf den Gesamtfestkörpergehalt des Reaktivsystems, bestehen.

13. Verfahren zur Herstellung eines, mit einem bei Raumtemperatur blockfesten, hitzereaktivierbaren, klebstoffbeschichteten Substrats, dadurch gekennzeichnet, daß ein Reaktivsystem nach Ansprüchen 1 bis 12 nach innigem Vermischen der Dispersionen von Harzen (I) und Härter (II) auf das Substrat durch Walzen, Sprühen, Streichen, Rakeln oder Tauchen aufgetragen und anschließend bei maximal 120°C getrocknet wird.

14. Verfahren zur Herstellung von Laminaten, dadurch gekennzeichnet, daß das Reaktivsystem nach Ansprüchen 1 bis 12 auf mindestens eines der zu verbindenden Substrate aufgetragen wird, diese unmittelbar anschließend flächig miteinander verbunden werden und die Härtung bei etwa 140°C bis 170°C erfolgt.

15. Verfahren zur Herstellung von Laminaten, dadurch gekennzeichnet, daß nach Anspruch 13 hergestellte beschichtete Substrate mit mindestens einem weiteren Substrat durch Reaktivierung und anschließende Aushärtung der Beschichtung bei etwa 140°C bis 170°C flächig miteinander verbunden werden.

16. Verwendung der Reaktivsysteme nach Ansprüchen 1 bis 12 zur Herstellung von mehrschichtigen Verbunden aus Metallfolien, Kunststoffolien, Geweben, Vliesen, Spezialpapieren und/oder Kartons.

17. Verwendung der Reaktivsysteme nach Ansprüchen 1 bis 12 zur Herstellung von hochtemperaturbeständigen gedruckten Schaltungen und Elektroisoliermaterialien wie Kabelumwicklungen, Abdeckfolien für Schaltungen und Wicklungen für Spulen.

## Claims

1. Two-component film-forming reactive systems for the surface-to-surface bonding and/or coating of substrates, more particularly for heat-sealable coatings, based on aqueous dispersions of
- at least one epoxy-curable resin (I) and
- epoxy compounds as the curing component (II),
characterized in that polyurethane polymers containing epoxy-reactive functional groups apart from amino groups are present as the curable resin (Ia) and aqueous dispersions of acrylate and/or methacrylate homopolymers or copolymers containing carboxyl and/or methylol groups are present as an additional curable resin (Ib), either 2 to 15% by weight, based on the solids content, of a polyaziridine or 2 to 30% by weight, based on the solids content of a phenol/resol resin being present as a third resin.

2. Two-component reactive systems as claimed in any of the preceding claims, characterized in that the ratio by weight of the curable resins (Ia):(Ib) is in the range from 99:1 to 25:75 and more particularly in the range from 98:2 to 50:50.

3. Two-component reactive systems as claimed in any of the preceding claims, characterized in that the ratio by weight of the curable resin (I) to the curing component (II) is in the range from 1:5 to 10:1 and preferably in the range from 1:1 to 5:1.

4. Two-component reactive systems as claimed in any of the preceding claims, characterized in that the epoxy-reactive functional groups of the polyurethane polymers are carboxyl and/or hydroxyl groups, more particularly carboxyl groups.

5. Two-component reactive systems as claimed in any of the preceding claims, characterized in that the polyurethane polymers have an average molecular weight of 7,000 to 50,000 and, more particularly, 10,000 to 30,000.

6. Two-component reactive systems as claimed in any of the preceding claims, characterized in that the polyurethane polymers contain at least an average of two epoxy-reactive functional groups.

7. Two-component reactive systems as claimed in any of the preceding claims, characterized in that the sum total of acid value and amine value of the polyurethane polymers is on average 0.1 to 40, more particularly 0.3 and 20 and preferably 0.5 to 5.

8. Two-component reactive systems as claimed in any of the preceding claims, characterized in that the acrylate and/or methacrylate homopolymers and/or copolymers have an average molecular weight of 50,000 to 300,000.

9. Two-component reactive systems as claimed in any of the preceding claims, characterized in that the acrylate and/or methacrylate homopolymers and/or copolymers have a sum total of acid value and OH value of 1 to 40, more particularly 3 to 15 and preferably 4 to 10.

10. Two-component reactive systems as claimed in any of the preceding claims, characterized in that the epoxy compounds have an epoxy equivalent of 100 to 4,000 and more particularly 150 to 600.

11. Two-component reactive systems as claimed in any of the preceding claims, characterized in that epoxy compounds based on bisphenol A, novolak and/or heterocyclic epoxy compounds are at least predominantly present.

12. Two-component reactive systems as claimed in any of the preceding claims, characterized in that, in addition to the dispersions of resin (I) and curing component (II), they consist of typical additives, such as catalysts, coupling agents, solvents, wetting aids, foam inhibitors, plasticizers in a total quantity of up to 30% by weight, based on the total solids content of the reactive system.

13. A process for the production of a substrate coated with a heat-reactivatable adhesive resistant to blocking at room temperature, characterized in that, after thorough mixing of the dispersions of resin (I) and curing component (II), a reactive system according to claims 1 to 12 is applied to the substrate by roll coating, spray coating, spread coating, knife coating or dip coating and then dried at a maximum temperature of 120°C.

14. A process for the production of laminates, characterized in that the reactive system claimed in claims 1 to 12 is applied to at least one of the substrates to be bonded which are then immediately joined surface-to-surface and cured at around 140 to 170°C.

15. A process for the production of laminates, characterized in that coated substrates produced by the process claimed in claim 13 are joined surface-to-surface to at least one other substrate by reactivation and subsequent curing of the coating at around 140°C to 170°C.

16. The use of the reactive systems claimed in claims 1 to 12 for the production of multilayer laminates of metal foils, plastic films, woven cloths, nonwovens, special papers and/or cardboard.

17. The use of the reactive systems claimed in claims 1 to 12 for the production of high-temperature-resistant printed circuits and electrical insulating materials, such as cable sheaths, cover films for circuits and windings for coils.

## Revendications

1. Système réactif apte à former un film à deux composants pour la liaison en surface et/ou le revêtement de substrats, en particulier pour des revêtements de thermoscellage à base de dispersions aqueuses:
- d'au moins une résine (I) durcissable avec un epoxyde et,
- de composés epoxydiques en tant que durcisseurs (II),
caractérisé en ce que, comme résine durcissable (Ia) on y inclut des polymères de polyuréthannes ayant des groupes fonctionnels réactifs vis-à-vis des epoxydes, en dehors des groupes amino, et comme résines durcissables supplémentaires (Ib) des dispersions aqueuses d'homo- ou de copolymères d'acrylate et/ou de méthacrylate avec des groupes carboxyle et/ou méthylol ainsi que comme troisième résine soit de 2 à 15 % en poids rapporté à la teneur en matière solide, d'une polyaziridine soit de 2 à 30 % en poids rapporté à la teneur en matière solide, d'une résine Phénol-Resol.

2. Système réactif à deux composants selon la revendication 1, caractérisé en ce que le rapport pondéral de la résine durcissable (Ia) à (Ib) se situe dans la zone de 99:1 à 25:75, en particulier dans la zone de 98:2 à 50:50.

3. Système réactif à deux composants selon l'une des revendications précédentes, caractérisé en ce que le rapport pondéral de la résine durcissable (I) au durcisseur (II) se situe dans la zone de 1:5 à 10:1, de préférence dans la zone de 1:1 à 5:1.

4. Système réactif à deux composants selon l'une des revendications précédentes, caractérisé en ce que les groupes fonctionnels réactifs vis-à-vis des epoxydes du polymère de polyuréthane, sont des groupes carboxyle et/ou hydroxyle, en particulier des groupes carboxyliques.

5. Système réactif à deux composants selon l'une des revendications précédentes, caractérisé en ce que les polymères de polyuréthanne possèdent un poids moléculaire moyen de 7000 à 50.000, en particulier de 10.000 à 30.000.

6. Système réactif à deux composants selon l'une des revendications précédentes, caractérisé en ce que les polymères de polyuréthanne renferment à chaque fois au moins en moyenne deux groupes fonctionnels réactifs vis-à-vis des epoxydes.

7. Système réactif à deux composants selon l'une des revendications précédentes, caractérisé en ce que la somme de l'indice d'acidité, de l'indice d'OH et de l'indice d'amine des polymères de polyuréthanne s'élève à en moyenne de 0,1 à 40, en particulier de 0,3 à 20 et de préférence de 0,5 à 5.

8. Système réactif à deux composants selon l'une des revendications précédentes, caractérisé en ce que les homo- ou copolymères d'acrylate et/ou de méthacrylate possèdent un poids moléculaire moyen de 50.000 à 300.000.

9. Système réactif à deux composants selon l'une des revendications précédentes, caractérisé en ce que les homo- et/ou copolymères d'acrylate et/ou méthacrylate possèdent une somme de l'indice d'acidité et de l'indice d'OH dans la zone de 1 à 40, en particulier de 3 à 15 et de préférence de 4 à 10.

10. Système réactif à deux composants selon l'une des revendications précédentes, caractérisé en ce que les composés epoxydiques possèdent un équivalent en epoxyde dans la zone de 100 à 4000, en particulier de 150 à 600.

11. Système réactif à deux composants selon l'une des revendications précédentes, caractérisé en ce qu'au moins d'une manière prépondérante des composés epoxydiques à base de bis-phénol A, de Novolak et/ou d'epoxydes hétérocycliques y sont contenus.

12. Systèmes réactifs à deux composants selon l'une des revendications précédentes, caractérisés en ce qu'à côté des dispersions de résine (I) et de durcisseur (II), ils consistent en des additifs habituels comme des catalyseurs, des adjuvants d'adhérence, des solvants, des adjuvants de réticulation, des agents antimousse, des agents plastifiants jusqu'à une quantité globale de 30 % en poids, rapporté à la teneur totale en matière solide du système réactif.

13. Procédé de production d'un substrat revêtu de colle, réactivable à la chaleur, solide en bloc à température ambiance, caractérisé en ce qu'un système réactifs selon les revendications 1 à 12 est appliqué après mélange intime de la dispersion de résine (I) et de durcisseur (II) sur le substrat par laminage, pulvérisation, étalement, raclage ou immersion et ensuite est séché à 120°C au maximum.

14. Procédé de production de produits stratifiés, caractérisé en ce que le système réactif selon les revendications 1 à 12 est appliqué sur au moins un des substrats à unir, que ceux-ci sont assemblés immédiatement ensuite en surface l'un avec l'autre, et que le durcissement s'effectue à environ 140°C à 170°C.

15. Procédé de production de produits stratifiés, caractérisé en ce que les substrats revêtus, produits selon la revendication 13 sont unis les uns avec les autres en surface avec au moins un substrat supplémentaire par réactivation et ensuite durcissement du revêtement à environ 140° à 170°C.

16. Utilisation des systèmes réactifs selon les revendications 1 à 12 en vue de la production de composites à plusieurs couches en feuilles de métal, feuilles de matière plastique, tissus, tissus non tissés, papiers spéciaux et/ou de carton.

17. Utilisation des systèmes réactifs selon les revendications 1 à 12 en vue de la production de circuits imprimés stables aux températures élevées et des matériaux d'isolation électrique comme des enroulements de câble, des feuilles de revêtement pour circuits et des enroulements pour bobines.
